# EUROPEAN PATENT SPECIFICATION

(11) **EP 1 447 280 B1**
(45) Date of publication and mention of the grant of the patent: **02.11.2006**
(21) Application number: 04003522.2
(22) Date of filing: 17.02.2004
(51) Int. Cl.: B60R 16/00

(54) **Vehicle electronic control unit**
Elektronisches Fahrzeugsteuergerät
Unité de commande dans une voiture

(30) Priority: 17.02.2003 JP 2003038842; 15.01.2004 JP 2004008541
(43) Date of publication of application: 18.08.2004
(73) Proprietor: DENSO CORPORATION, Kariya-city, Aichi-pref. 448-8661 (JP)
(72) Inventor: Kato, Keiichi, Kariya-city Aichi-pref., 448-8661 (JP); Morishima, Tamotsu, Kariya-city Aichi-pref., 448-8661 (JP)
(74) Representative: Winter, Brandl, Fürniss, Hübner Röss, Kaiser, Polte Partnerschaft Patent- und Rechtsanwaltskanzlei

(56) References cited:
- EP-A- 0 805 619
- US-A- 5 170 330

## Description

The present invention relates to a vehicle electronic control unit.

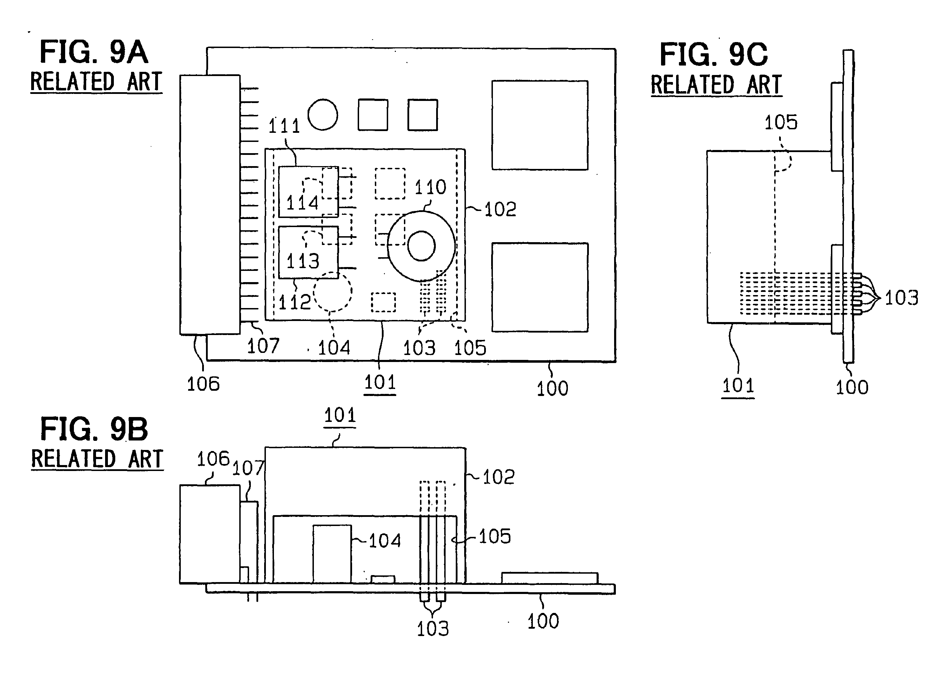

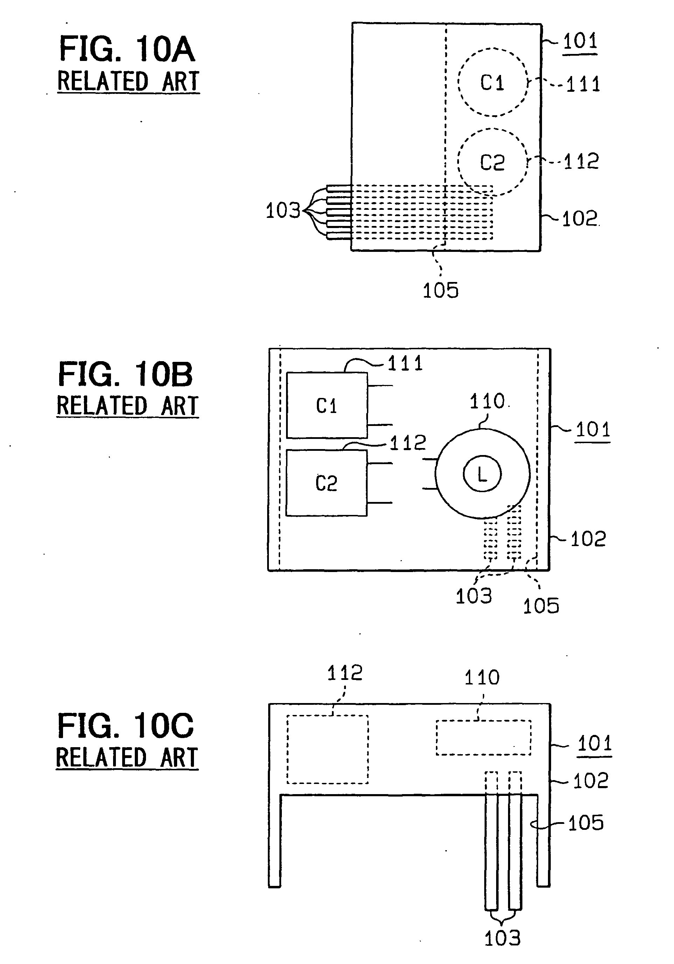

As a vehicle electronic control unit (electronic control unit for a vehicle), a unit shown in FIGS. 9A to 9C is proposed. In FIGS. 9A to 9C, a component carrier 101 is mounted on a printed board 100. The component carrier 101 is used for mounting large electronic components on the printed board 100 in three dimensions in order to save size of the printed board 100. In the component carrier 101, as shown in FIGS. 10A to 10C, the large electronic components are disposed within a resin mold unit 102 and connection terminals 103 protrude from the resin mold unit 102. Further, a component accommodating portion (hollowed portion) 105 is formed in the resin mold unit 102. To the contrary, relatively large components (e.g., 104), which are not so large as to be mounted on the component carrier 101, are mounted on the printed board 100 in FIGS. 9A to 9C. In a place where the relatively large components are mounted, the component carrier 101 is disposed in a state where the relatively large components are accommodated in the component accommodating portion 105. That is, the relatively large component can be disposed in the component accommodating portion 105 of the component carrier 101. Further, a connector 106 is disposed on the printed board 100 and is electrically connected to the printed board 100 by pins 107.

However, the following disadvantages occur when a power device (e.g., power transistor, diode), which is originally mounted on the printed board 100 for heat radiation, exists in a circuit.

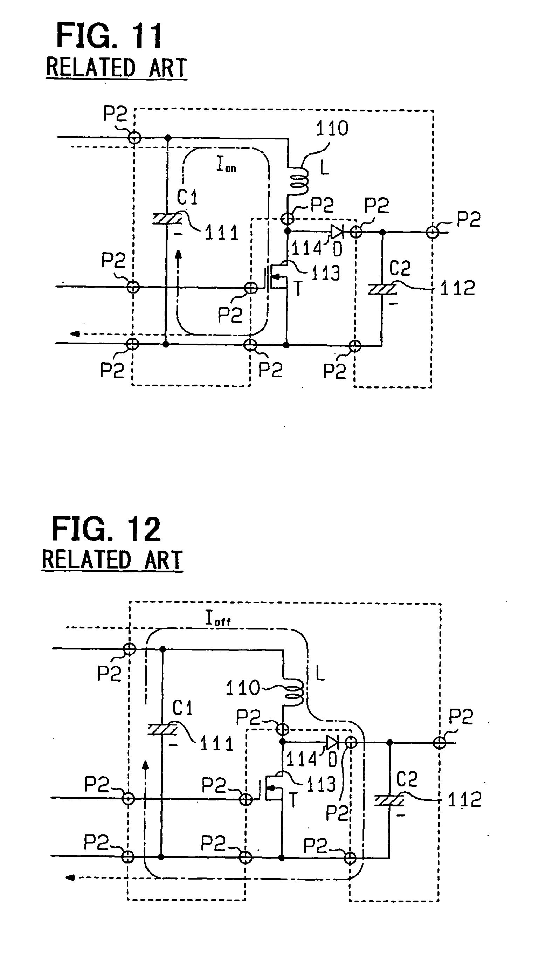

Here, the circuit is, for example, a DC-DC converter in FIGS. 11 and 12. The DC-DC converter includes a reactor 110, capacitors 111, 112, a power transistor 113 and a diode 114. When the DC-DC converter is operated, sharp large current flows instantaneously in a path of ON-state current Ion shown by a dash-dot line in FIG. 11. Further, sharp large current instantaneously flows in a path of OFF-state current Ioff shown by a dash-dot line in FIG. 12.

Here, the reactor 110 and the capacitors 111, 112 in FIGS. 11 and 12 are the large electronic components. Therefore, these are disposed in the component carrier 101 as shown in FIGS. 10A to 10C. In this case, a loop of large current circulates between the component carrier 101 and the printed board 100 in FIGS. 9A to 9C, because the power transistor 113 is mounted on the printed board 100 as shown in FIGS. 9A to 9C. Therefore, efficiency of the DC-DC converter is reduced because loop resistance is large. Furthermore, a disadvantage of noise arises. Specifically, the loop circuit in which the sharp large current flows acts as an antenna and the noise is radiated. In addition, other circuits are affected by the noise. Furthermore, the power transistor 113 needs special heat radiation.

In addition, the circuit shown in FIGS. 11 and 12 needs to be disposed relatively near the connector 106 because the circuit deals with the large current. According to the same reason, a power source circuit and the like also need to be disposed near the connector 106. Accordingly, the relatively large components such as an aluminum capacitor 104 in FIGS. 9A to 9C need to be disposed in the component accommodating portion 105 of the component carrier 101. Here, the relatively large components are large in a longitudinal direction although they are not so large as to be mounted in the component carrier 101. Therefore, wirings P2 in FIGS. 11 and 12, which are wirings between the component carrier 101 and the printed board 100 and are structured by using the connection terminals 103 in FIGS. 9A to 9C and FIGS. 10A to 10C, must be long. However, the windings P2 are to be shortened, a connecting position between the component carrier 101 and the printed board 100 needs to be optimized. This causes large restriction regarding component arrangement on the printed board 100. Therefore, difficulty of design occurs.

In view of the foregoing problem, it is an object of the present invention to provide a vehicle electronic control unit which can be increased in efficiency of a circuit while noise can be reduced.

According to the present invention, all of electronic components including a power device, which structure a circuit in which current flows, are disposed within a resin mold unit in a state where all of the electronic components are wired so that a loop circuit is structured as a current path. Then, the electronic components are mounted on a circuit board by using a connection terminal which protrudes from the resin mold unit. Therefore, noise and efficiency of the circuit can be improved because a loop of large current can be reduced.

Additional objects and advantages of the present invention will be more readily apparent from the following detailed description of preferred embodiments when taken together with the accompanying drawings, in which:
FIG. 1 is a circuit diagram showing a vehicle electronic control unit according to an embodiment of the invention;
FIG. 2 is a longitudinal sectional view showing the vehicle electronic control unit according to the embodiment;
FIGS. 3A to 3D are schematic left side, rear side, top plan and front side views showing a component carrier according to the embodiment respectively;
FIGS. 4A to 4C are schematic top plan, front side and right side views showing devices which are accommodated in a housing respectively;
FIG. 5 is a plan view showing a power transistor package;
FIG. 6 is a sectional view showing the power transistor package, taken along line VI - VI in FIG. 5;
FIG. 7 is a circuit diagram showing an ON-state current path in a DC-DC converter circuit according to the embodiment;
FIG. 8 is a circuit diagram showing an OFF-state current path in the DC-DC converter circuit according to the embodiment;
FIGS. 9A to 9C are schematic top plan, front side and right side views showing a vehicle electronic control unit in order to explain a related art respectively;
FIGS. 10A to 10C are schematic left side, top plan and front side views showing a component carrier according to the related art respectively;
FIG. 11 is a circuit diagram showing an ON-state current path in a DC-DC converter circuit according to the related art; and
FIG. 12 is a circuit diagram showing an OFF-state current path in the DC-DC converter circuit according to the related art.

### [Embodiment]

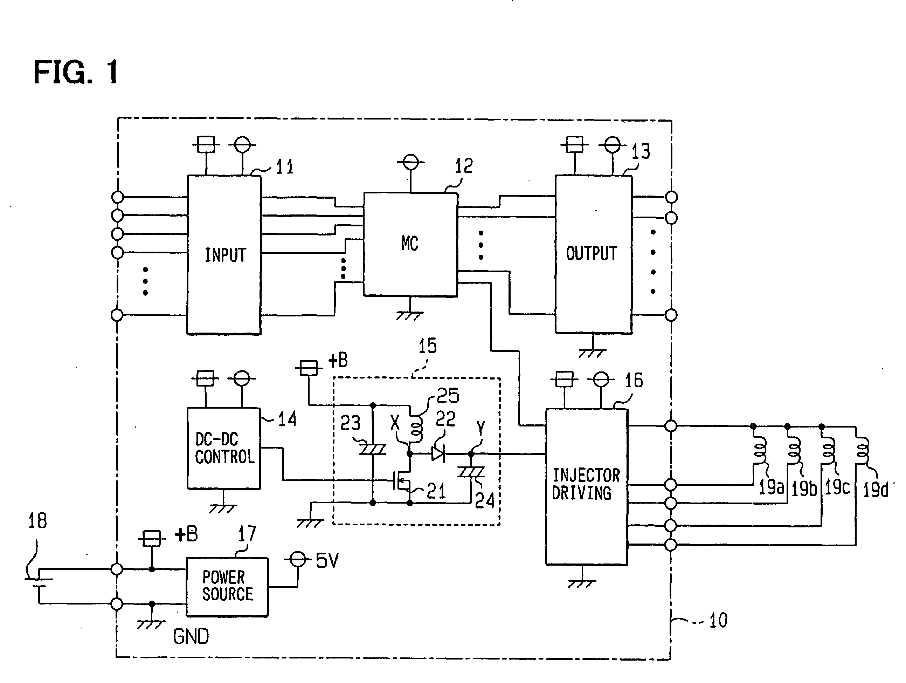

As shown in FIG. 1, a vehicle electronic control unit (ECU) 10 according to the embodiment includes an input circuit 11, a microcomputer 12, an output circuit 13, a DC-DC converter control circuit 14, a DC-DC converter circuit 15, an injector driving circuit 16 and a power source circuit 17. The power source circuit 17 is connected to an outside battery 18 and generates voltage of 5 V from voltage (e.g., 12 V) of the battery 18. Various outside sensors are connected to the input circuit 11. Outside injectors 19a, 19b, 19c, 19d are connected to the injector driving circuit 16. Other outside devices are connected to the output circuit 13.

The DC-DC converter circuit 15 includes a power transistor 21, a diode 22, capacitors 23, 24 and a reactor 25. voltage (+B) of the battery 18 is applied to a series circuit of the reactor 25 and the power transistor 21. The capacitor 23 is connected parallel to the series circuit of the reactor 25 and the power transistor 21. Further, a connection point X between the reactor 25 and the power transistor 21 is connected to a ground through a series circuit of the diode 22 and the capacitor 24. A connection point Y between the diode 22 and the capacitor 24 is connected to the injector driving circuit 16. A gate terminal of the power transistor 21 is connected to the DC-DC converter control circuit 14. The DC-DC converter control circuit 14 controls ON/OFF of the power transistor 21. High voltage is generated in the DC-DC converter circuit 15 and is supplied to the injector driving circuit 16.

The microcomputer 12 receives various sensor signals through the input circuit 11 and performs various calculations. Then, the microcomputer 12 outputs various signals to the outside through the output circuit 13. Further, the microcomputer 12 controls the injector driving circuit 16 and the high voltage is supplied to the injectors 19a, 19b, 19c, 19d at a predetermined timing so that a suitable amount of fuel is injected. That is, the vehicle ECU 10 recognizes an engine operating condition by the sensor signals and performs the various calculations. Then, the injector (actuator) 19a, 19b, 19c, 19d are driven so that the engine is operated suitably.

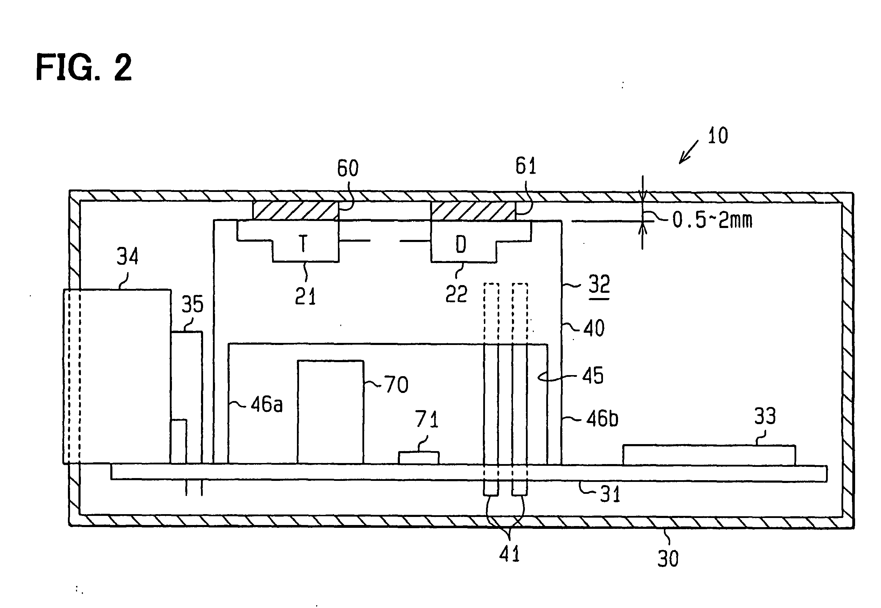

In the ECU 10 according to the embodiment, a component carrier 32 shown in FIG. 2 is used for mounting large electronic components on a printed board in three dimensions in order to save size of the printed board.

The component carrier 32 is disposed in an aluminum case 30 as a housing. The aluminum case 30 is box-shaped. Inside the aluminum case 30, a printed board 31 is disposed as a circuit board. On the printed board 31, the component carrier 32 is mounted while electronic components such as a microcomputer 33 are mounted. Further, a connector 34 is mounted on a side face of the aluminum case 30. The connector 34 has connector pins 35. The connector pins 35 are soldered in a state where the connector pins 35 penetrate thorough the printed board 31.

In FIG. 2, the pins 35 of the connector 34 are connected to an end of a wire (not shown) through an opposite connector. The battery, the various sensors, the injectors and the like are connected to this wire. That is, the devices inside the aluminum case 30 of the ECU 10 are connected to the battery, the various sensors and the injectors (engine control actuators) 19a, 19b, 19c, 19d through the wire in the connector 34.

The component carrier 32 is mainly made of a resin. The component carrier 32 has a cavity for holding the large electronic components. In order to electrically connect a lead of the large components and a terminal for mounting on the printed board 31, an electrically conductive structure is formed within the resin by insert molding.

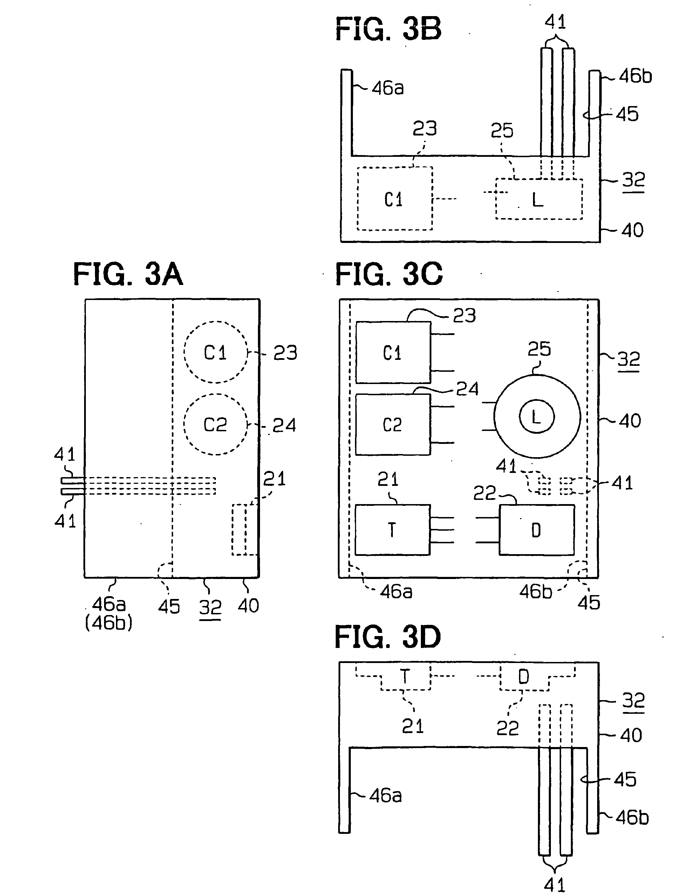

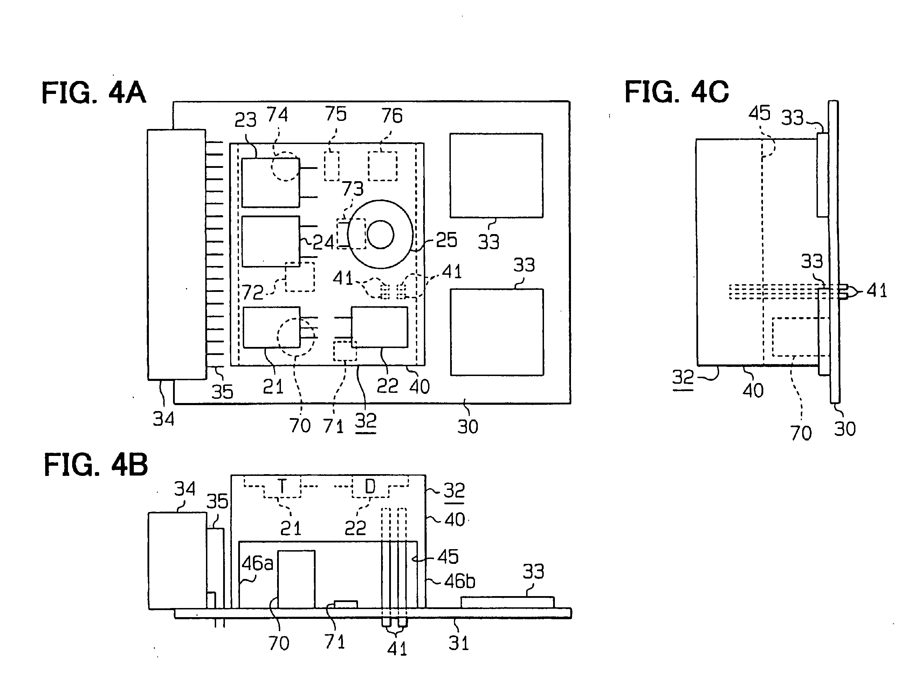

In the component carrier 32 shown in FIGS. 3A to 3D, the power transistor 21, the diode 22, the capacitors 23, 24 and the reactor 25, which are components structuring the DC-DC converter circuit 15, are disposed within a resin mold unit 40 in a state where they are connected by required wiring. The power transistor 21 and the diode 22 are heat generating components, which generate heat because of driving. The resin mold unit 40 is a rectangular parallelepiped as a whole shape. However, a component accommodating portion 45 is formed on a bottom surface (surface facing the printed board 31) of the resin mold unit 40. Specifically, plate-shaped poles 46a, 46b are provided on the right and left sides of the resin mold unit 40. The portion between the poles 46a, 46b is the component accommodating portion (hollowed portion) 45. Other electronic components 70-76, which are disposed in a portion where the resin mold unit 40 is mounted on the printed board 31 and are different from the electronic components 21-25, are accommodated in the component accommodating portion 45 as shown in FIGS. 4A to 4C.

In FIGS. 3A to 3D, four connection terminals (pins) 41 are provided in the component accommodating portion 45 of the resin mold unit 40. Specifically, the four connection terminals 41 protrude downwardly in the component accommodating portion 45 on the bottom surface of the resin mold unit 40. The component carrier 32 is mounted on the printed board 31 by using the four connection terminals 41. That is, the four connection terminals 41 of the component carrier 32 penetrate through the printed board 31 as shown in FIGS. 4A to 4C. By soldering in this state, the component carrier 32 is electrically connected to the printed board 31.

To the contrary, the electronic components 70-76 are disposed on the printed board 31 as shown in FIGS. 4A to 4C. The electronic components 70-76 are, for example, electronic components which structure a power source circuit. The electronic components 70-76 are disposed relatively near the connector 34 because they deal with large current. Specifically, the electronic components 70-76 are an aluminum capacitor, a transistor, a diode and the like. Especially, the electronic component 70 is a relatively large component such as the aluminum capacitor, which is large in a longitudinal direction although not so large as to be mounted in the component carrier 32. Here, the component carrier 32 is disposed in a place where the electronic components 70-76 are disposed on the printed board 31. That is, the DC-DC converter circuit 15 in FIG. 1 is disposed in a place relatively near the connector 34 because it deals with large current. Further, the electronic components 70-76 are accommodated in the component accommodating portion 45 formed in the resin mold unit 40 of the component carrier 32. Thus, the relatively large components such as the aluminum capacitor are disposed in the component accommodating portion 45 of the component carrier 32.

In FIGS. 3A to 3D, the power transistor 21 and the diode 22 show an example of a package which is generally known as TO-220. The power transistor 21 and the diode 22 are mounted so that a rear side of the package corresponds to a top side (surface of the resin mold unit 40) of the component carrier 32 or protrudes upper than the top side of the component carrier 32.

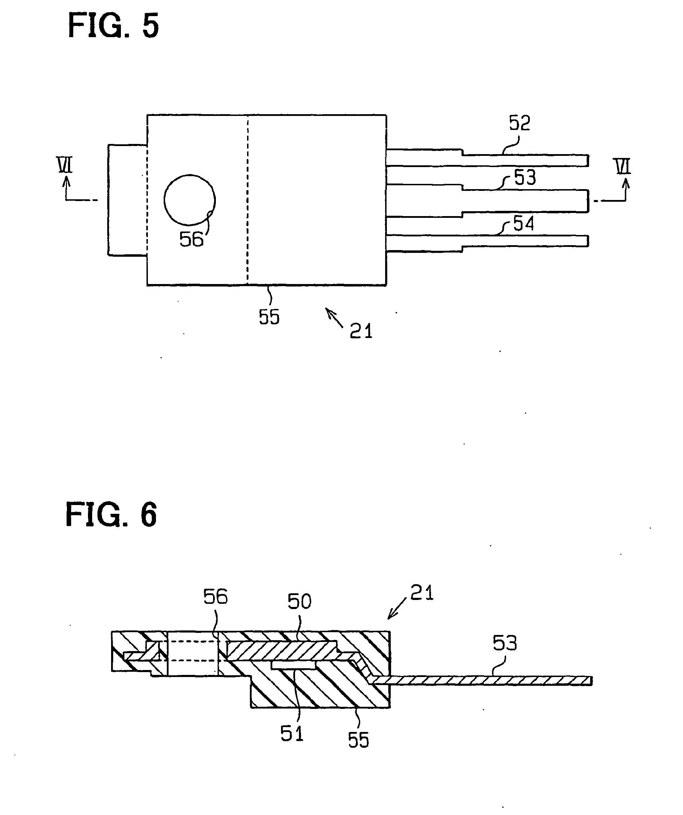

In FIGS. 5 and 6, a power transistor chip 51 is mounted on a metal frame 50. The power transistor chip 51 is electrically connected to lead frames 52, 53, 54. The metal frame 50, the power transistor chip 51 and a part of the lead frames 52, 53, 54 are molded by a resin 55. Further, a through hole 56 is provided in the resin 55.

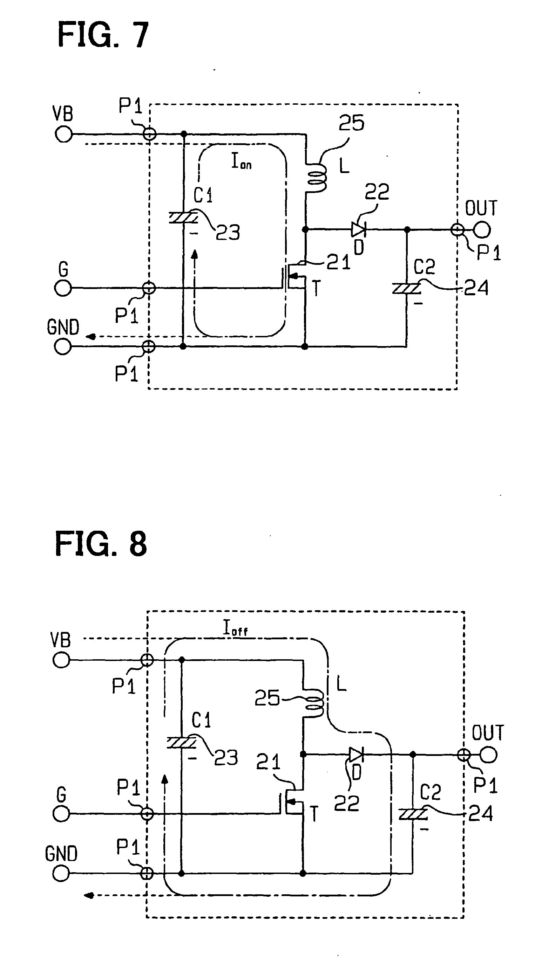

In FIG. 7, a battery terminal (VB terminal), a ground terminal (GND terminal), a gate connection terminal (G terminal) and an output terminal (OUT terminal) are provided as external terminals. These four terminals P1 correspond to the four connection terminals 41. The gate terminal of the power transistor 21 is connected to the gate connection terminal. The power transistor 21 is turned on and off by a signal from the gate connection terminal, that is, the power transistor 21 is driven as a switch. Voltage higher than the power source voltage is generated by this operation and applied to the output terminal.

When the power transistor 21 is turned on, sharp large current flows in a loop shown by ON-state current Ion in FIG. 7 and electromagnetic energy is stored in the reactor 25. When the power transistor 21 is turned off, sharp large current flows in a loop shown by OFF-state current Ioff in FIG. 8 and the electromagnetic energy in the reactor 25 is stored as voltage of the capacitor 24.

In the embodiment, all of the components 21-25 structuring the DC-DC converter circuit are integrally molded in the component carrier 32 and are connected by required wiring of the circuit within the resin mold material 40. Therefore, the loop of the large current is closed in the component carrier 32 in FIGS. 3A to 3D. Accordingly, even when the wirings P1, which are wirings between the component carrier 32 and the printed board 31 in FIGS. 7 and 8 and are structured by using the connection terminals 41 in FIGS. 3A to 3D, are long, the sharp large current does not flow in the wirings P1. Therefore, noise radiation is prevented and other circuits on the printed board 31 are not affected by the induction noise and the like. Furthermore, by disposing the power transistor 21 and the diode 22 in FIGS. 7 and 8 on the component carrier 32, the noise can be reduced even when portions (the connection terminals 41 in FIGS. 3A to 3D) corresponding to the windings P1 in FIGS. 7 and 8 are long. Therefore, this does not cause restriction regarding device arrangement on the printed board 31 and high flexibility of design can be achieved.

As shown in FIG. 2, rear sides of the power transistor 21 and the diode 22 are spaced about 0.5 - 2 mm from the aluminum case 30 made by aluminum die casting or the like. The space is filled with members 60, 61 with high thermal-conductivity, such as heat conduction gel. This is because a rear side (upper side in FIG. 2) of the package is a heat radiating portion of a silicon chip in the TO-220 package of the embodiment. Thus, heat generated in the power transistor 21 and the diode 22 is radiated to the aluminum case 30 through the members 60, 61 with high thermal-conductivity.

As described above, the embodiment is structured so that heat is directly radiated from the components mounted on the component carrier 32 to the aluminum case 30 as the housing. Therefore, heat radiation characteristics of the heat generating components such as the power transistor and the diode, which are originally to be mounted on the printed board, can be improved. Furthermore, size of the printed board can be reduced because the heat generating components are mounted in the component carrier 32.

A silicon heat conduction gel can be used as the members 60, 61 with high thermal-conductivity.

The embodiment has the following characteristics.
(a) As shown in FIGS. 1, 4A to 4C, 7 and 8, all of the power transistor 21, the diode 22, the capacitors 23, 24 and the rector 25 are disposed within the resin mold unit 40 in the state where they are wired so that the loop circuit is structured as the current path. Then, the power transistor 21, the diode 22, the capacitors 23, 24 and the rector 25 are mounted on the printed board 31 by using the connection terminals 41 which protrude from the resin mold unit 40. Therefore, the large current loop (power circuit loop) can be reduced. As a result, reducing noise and increasing circuit efficiency (reducing power loss) can be achieved. More specifically, other circuits on the printed board 31 are not affected by the induction noise because of the sharp large current and the like.
(b) Similarly, as shown in FIGS. 1, 4A to 4C, 7 and 8, the power transistor 21 and the diode 22, which are the heat generating components, are disposed within the resin mold unit 40 in the state where the power transistor 21 and the diode 22 are wired so that the loop circuit is structured as the current path. Then, the heat generating components 21, 22 are mounted on the printed board 31 by using the connection terminals 41 which protrude from the resin mold unit 40. Furthermore, the heat radiating portion of the heat generating components 21, 22 and the aluminum case 30 are connected thermally. Therefore, the large current loop (power circuit loop) can be reduced. As a result, reducing noise and increasing circuit efficiency (reducing power loss) can be achieved. Further, miniaturization of the printed board 31 can be realized because the heat generating components 21, 22 are mounted on the component carrier 32. Furthermore, it is difficult to ensure a heat radiation path when the heat generating components are mounted on the printed board. Therefore, a special structure is required for heat radiation. However, in the embodiment, heat can be directly radiated to the aluminum case 30 in a state where the heat generating components 21, 22 are disposed within the resin mold unit 40.
(c) In (a) or (b), as shown in FIG. 2, the heat generating components 21, 22 are disposed within the resin mold unit 40 so that the heat radiating portion side of the heat generating components 21, 22 faces the aluminum case 30. Therefore, temperature rise of the heat generating components 21, 22 can be restrained because thermal resistance from the heat radiating portion of the heat generating components 21, 22 to the aluminum case 30 with heat radiating structure can be reduced.
(d) In (a), as shown in FIG. 2, the members 60, 61 with high thermal-conductivity are disposed between the heat generating components 21, 22 and the aluminum case 30. Therefore, temperature rise of the heat generating components 21, 22 can be restrained because thermal resistance from the heat generating components 21, 22 to the aluminum case 30 with heat radiating structure can be reduced. In addition, size of clearance between the heat generating components 21, 22 and the aluminum case 30 can be absorbed by adjusting an amount of the members 60, 61 with high thermal-conductivity. Therefore, design of size becomes easier.
(e) In (b), as shown in FIG. 2, the members 60, 61 with high thermal-conductivity are disposed between the heat radiating portion of the heat generating components 21, 22 and the aluminum case 30. Therefore, temperature rise of the heat generating components 21, 22 can be restrained because thermal resistance from the heat radiating portion of the heat generating components 21, 22 to the aluminum case 30 with heat radiating structure can be reduced. In addition, size of clearance between the heat generating components 21, 22 and the aluminum case 30 can be absorbed by adjusting an amount of the members 60, 61 with high thermal-conductivity. Therefore, design of size becomes easier.
   Especially, in (d) and (e), when materials with flexibility, such as the silicon heat conduction gel, are used as the members 60, 61 with high thermal-conductivity, the present invention becomes more practical.
(f) As shown in FIGS. 4A to 4C, the component accommodating portion 45, which opens on a surface facing the printed board 31, is formed in the resin mold unit 40. The electronic components 70-76, which are disposed in a portion where the resin mold unit 40 is mounted on the printed board 31 and are different from the electronic components 21-25, are accommodated in the component accommodating portion 45. Therefore, size of the printed board 31 can be reduced.
(g) The circuit is assumed to be the DC-DC converter circuit. Within the resin mold unit 40, the power transistor 21, the diode 22, the capacitors 23, 24 and the reactor 25, which are components structuring the DC-DC converter circuit, are disposed in a state where they are connected by required wiring. Therefore, it is preferable because the noise can be further reduced in a structure for supplying the large current, in particular, to the injector driving circuit.

## Claims

1. A vehicle electronic control unit, comprising:
a housing (30);
a circuit board (31) disposed in the housing (30);
a power device (21) and a circuit component (22-25) for structuring a circuit in which current flows while the power device (21) is driven;
a resin mold unit (40) including therein both the power device (21) and the circuit component (22-25) in a state where both the power device (21) and the circuit component (22-25) are wired so that a loop circuit is structured as a current path; and
a connection terminal (41) protruding from the resin mold unit (40) to mount both the power device (21) and the circuit component (22-25) on the circuit board (31).

2. A vehicle electronic control unit, comprising:
a housing (30);
a circuit board (31) disposed in the housing (30);
a heat generating component (21) and a circuit component (22-25) for structuring a circuit in which current flows while the heat generating component (21) is driven;
a resin mold unit (40) including therein both the heat generating component (21) and the circuit component (22-25) in a state where both the heat generating component (21) and the circuit component (22-25) are wired so that a loop circuit is structured as a current path; and
a connection terminal (41) protruding from the resin mold unit (40) to mount both the heat generating component (21) and the circuit component (22-25) on the circuit board (31), wherein
a heat radiating portion of the heat generating component (21) and the housing (30) are connected thermally.

3. The vehicle electronic control unit according to claim 1 or 2, wherein the power device (21) or the heat generating component (21) is disposed so that a heat radiating portion of the power device (21) or the heat generating component (21) within the resin mold unit (40) faces the housing (30).

4. The vehicle electronic control unit according to claim 1, further comprising:
a member (60, 61) with high thermal-conductivity disposed between the power device (21) and the housing (30).

5. The vehicle electronic control unit according to claim 2, further comprising:
a member (60, 61) with high thermal-conductivity disposed between the heat radiating portion of the heat generating component (21) and the housing (30).

6. The vehicle electronic control unit according to claim 4 or 5, wherein the member (60, 61) with high thermal-conductivity has flexibility.

7. The vehicle electronic control unit according to any one of claims 1-6, wherein:
the resin mold unit (40) has a component accommodating portion (45), opening on a surface facing the circuit board (31); and
the component accommodating portion (45) accommodates an electronic component (70-76), which is disposed in a portion where the resin mold unit (40) is mounted on the circuit board (31) and is different from the power device (21) or the heat generating component (21) and the circuit component (22-25).

8. The vehicle electronic control unit according to any one of claims 1-7, wherein:
the circuit in which current flows is a DC-DC converter circuit including a power transistor (21), a diode (22), a capacitor (23, 24) and a reactor (25); and
the circuit is within the resin mold unit (40) in a state where the power transistor (21), the diode (22), the capacitor (23, 24) and the reactor (25) are connected by required wiring.

## Patentansprüche

1. Ein elektronisches Fahrzeugsteuergerät, aufweisend:
ein Gehäuse (30);
eine Platine (31), die in dem Gehäuse (30) angeordnet ist;
eine Leistungsvorrichtung (21) und ein Schaltkreisbauteil (22-25) zum Bilden eines Schaltkreises, in welchem Strom fließt, wenn die Leistungsvorrichtung (21) betrieben wird;
eine Harzgusseinheit (40), welche in sich sowohl die Leistungsvorrichtung (21) als auch das Schaltkreisbauteil (22-25) in einem Zustand enthält, in welchem sowohl die Leistungsvorrichtung (21) als auch das Schaltkreisbauteil (22-25) so verdrahtet sind, dass als Strompfad ein Schleifenschaltkreis gebildet ist; und
einen Verbindungsanschluss (41), der von der Harzgusseinheit (40) vorsteht, um sowohl die Leistungsvorrichtung (21) als auch das Schaltkreisbauteil (22-25) auf der Platine (31) anzuordnen.

2. Ein elektronisches Fahrzeugsteuergerät, aufweisend:
ein Gehäuse (30);
eine Platine (31), die in dem Gehäuse (30) angeordnet ist;
ein Wärme erzeugendes Bauteil (21) und ein Schaltkreisbauteil (22-25) zum Bilden eines Schaltkreises, in welchem Strom fließt, wenn das Wärme erzeugende Bauteil (21) betrieben wird;
eine Harzgusseinheit (40), welche in sich sowohl das Wärme erzeugende Bauteil (21) als auch das Schaltkreisbauteil (22-25) in einem Zustand enthält, in welchem sowohl das Wärme erzeugende Bauteil (21) als auch das Schaltkreisbauteil (22-25) so verdrahtet sind, dass als Strompfad ein Schleifenschaltkreis gebildet ist; und
einen Verbindungsanschluss (41), der von der Harzgusseinheit (40) vorsteht, um sowohl das Wärme erzeugende Bauteil (21) als auch das Schaltkreisbauteil (22-25) auf der Platine (31) anzuordnen, wobei
ein wärmeabstrahlender Abschnitt des Wärme erzeugenden Bauteils (21) und das Gehäuse (30) themisch verbunden sind.

3. Das elektronische Fahrzeugsteuergerät nach Anspruch 1 oder 2, wobei die Leistungsvorrichtung (21) oder das Wärme erzeugende Bauteil (21) so angeordnet ist, dass ein Wärme abstrahlender Abschnitt der Leistungsvorrichtung (21) oder des Wärme erzeugenden Bauteils (21) innerhalb der Harzgusseinheit (40) zu dem Gehäuse (30) weist.

4. Das elektronische Fahrzeugsteuergerät nach Anspruch 1, weiterhin mit: einem Bauteil (60, 61) mit hoher thermischer Leitfähigkeit, welches zwischen der Leistungsvorrichtung (21) und dem Gehäuse (30) angeordnet ist.

5. Das elektronische Fahrzeugsteuergerät nach Anspruch 2, weiterhin mit: einem Bauteil (60, 61) mit hoher thermischer Leitfähigkeit, welches zwischen dem Wärme abstrahlenden Abschnitt des Wärme erzeugenden Bauteils (21) und dem Gehäuse (30) angeordnet ist.

6. Das elektronische Fahrzeugsteuergerät nach Anspruch 4 oder 5, wobei das Bauteil (60, 61) mit hoher thermischer Leitfähigkeit Flexibilität hat.

7. Das elektronische Fahrzeugsteuergerät nach einem der Ansprüche 1 bis 6, wobei:
die Harzgusseinheit (40) einen Bauteilaufnahmeabschnitt (45) hat, der sich in einer Oberfläche öffnet, die zu der Platine (31) weist; und
der Bauteilaufnahmeabschnitt (45) ein elektronisches Bauteil (70-76) aufnimmt, welches in einem Abschnitt angeordnet ist, wo die Harzgusseinheit (40) auf der Platine (31) angeordnet ist und welches unterschiedlich zur Leistungsvorrichtung (21) oder dem Wärme erzeugenden Bauteil (21) und dem Schaltkreisbauteil (22-25) ist.

8. Das elektronische Fahrzeugssteuergerät nach einem der Ansprüche 1-7, wobei:
der Schaltkreis, in welchem Strom fließt, ein DC-DC-Wandlerschaltkreis mit einem Leistungstransistor (21), einer Diode (22), einem Kondensator (23, 24) und einer Drossel (25) ist; und
der Schaltkreis sich innerhalb der Harzgusseinheit (40) in einem Zustand befindet, wo der Leistungstransistor (21), die Diode (22), der Kondensator (23, 24) und die Drossel (25) durch eine benötigte Verdrahtung miteinander verbunden sind.

## Revendications

1. Unité de commande électronique d'un véhicule, comprenant :
un boîtier (30) ;
une carte de circuits imprimés (31) disposée dans le boîtier (30) ;
un dispositif d'alimentation (21) et un composant de circuit (22 à 25) pour structurer un circuit dans lequel un courant circule alors que le dispositif d'alimentation (21) est entraîné ;
une unité moulée en résine (40) comprenant dans celle-ci à la fois le dispositif d'alimentation (21) et le composant de circuit (22 à 25) dans un état où à la fois le dispositif d'alimentation (21) et le composant de circuit (22 à 25) sont câblés de sorte qu'un circuit en boucle est structuré sous forme d'un trajet de courant ; et
un terminal de connexion (41) faisant saillie à partir de l'unité moulée en résine (40) pour monter à la fois le dispositif d'alimentation (21) et le composant de circuit (22 à 25) sur la carte de circuits imprimés (31).

2. Unité de commande électronique d'un véhicule, comprenant :
un boîtier (30) ;
une carte de circuits imprimés (31) disposée dans le boîtier (30) ;
un composant générant de la chaleur (21) et un composant de circuit (22 à 25) pour structurer un circuit dans lequel un courant circule alors que le composant générant de la chaleur (21) est entraîné ;
une unité moulée en résine (40) comprenant dans celle-ci à la fois le composant générant de la chaleur (21) et le composant de circuit (22 à 25) dans un état où à la fois le composant générant de la chaleur (21) et le composant de circuit (22 à 25) sont câblés de sorte qu'un circuit en boucle est structuré sous forme d'un trajet de courant ; et
un terminal de connexion (41) faisant saillie à partir de l'unité moulée en résine (40) pour monter à la fois le composant générant de la chaleur (21) et le composant de circuit (22 à 25) sur la carte de circuits imprimés (31), dans lequel
une partie de rayonnement thermique du composant générant de la chaleur (21) et le boîtier (30) sont raccordés de manière thermique.

3. Unité de commande électronique de véhicule selon la revendication 1 ou 2, dans laquelle le dispositif d'alimentation (21) ou le composant générant de la chaleur (21) est disposé de sorte qu'une partie de rayonnement thermique du dispositif d'alimentation (21) ou du composant générant de la chaleur (21) à l'intérieur de l'unité moulée en résine (40) fait face au boîtier (30).

4. Unité de commande électronique de véhicule selon la revendication 1, comprenant en outre :
un élément (60, 61) ayant une conductivité thermique élevée disposé entre le dispositif d'alimentation (21) et le boîtier (30).

5. Unité de commande électronique de véhicule selon la revendication 2, comprenant en outre :
un élément (60, 61) ayant une conductivité thermique élevée disposé entre la partie de rayonnement thermique du composant générant de la chaleur (21) et le boîtier (30).

6. Unité de commande électronique d'un véhicule selon la revendication 4 ou 5, dans laquelle l'élément (60, 61) ayant une conductivité thermique élevée présente une souplesse.

7. Unité de commande électronique d'un véhicule selon l'une quelconque des revendications 1 à 6, dans laquelle :
l'unité moulée en résine (40) présente une partie logeant un composant (45), donnant sur une surface faisant face à la carte de circuits imprimés (31) ; et
la partie logeant un composant (45) loge un composant électronique (70 à 76), qui est disposé dans une partie où l'unité moulée en résine (40) est montée sur la carte de circuits imprimés (31) et est différente du dispositif d'alimentation (21) ou du composant générant de la chaleur (21) et du composant de circuit (22 à 25).

8. Unité de commande électronique d'un véhicule selon l'une quelconque des revendications 1 à 7, dans laquelle:
le circuit dans lequel le courant circule est un circuit convertisseur continu-continu comprenant un transistor de puissance (21,) une diode (22), un condensateur (23, 24) et un réacteur (25) ; et
le circuit est à l'intérieur de l'unité moulée en résine (40) dans un état où le transistor de puissance (21), la diode (22), le condensateur (23, 24) et le réacteur (25) sont raccordés par un câblage requis.
